# EUROPÄISCHE PATENTSCHRIFT

(11) **EP 1 832 886 B1**
(45) Veröffentlichungstag und Bekanntmachung des Hinweises auf die Patenterteilung: **01.04.2015**
(21) Anmeldenummer: 06024651.9
(22) Anmeldetag: 28.11.2006
(51) Int. Cl.: G01R 31/28, H01L 21/677

(54) **Vorrichtung und Verfahren zum Testen von elektronischen Bauteilen**
Device and method for testing electronic components
Dispositif et procédé destiné au test de composants électroniques

(30) Priorität: 08.03.2006 EP 06004765
(43) Veröffentlichungstag der Anmeldung: 12.09.2007
(73) Patentinhaber: Rasco GmbH, 83059 Kolbermoor (DE)
(72) Erfinder: Langner, Alfred, 83088 Kiefersfelden (DE); Hellmuth, Christian, 83071 Stephanskirchen (DE)
(74) Vertreter: Grünecker, Kinkeldey, Stockmair & Schwanhäusser

(56) Entgegenhaltungen:
- WO-A-92/04989
- DE-A1- 3 634 860
- DE-A1- 3 715 671
- DE-A1- 3 719 148
- US-A- 4 506 213
- US-A- 5 801 527
- US-A- 5 919 024
- US-A1- 2003 117 162
- US-A1- 2004 164 723

## Beschreibung

Elektronische Bauteile werden üblicherweise nach dem Herstellen auf ihre elektronischen bzw. elektrischen Eigenschaften getestet. Dies kann sowohl bei Umgebungstemperatur als auch bei erhöhter oder erniedrigter Temperatur durchgeführt werden.

Bekannt ist es elektronische Bauteile einem elektrischen Testkopf zuzuführen, der dann die elektronischen Eigenschaften des Bauteils testet.

Hierbei ist es von Vorteil, wenn das Zu- und Abführen von elektronischen Bauteilen zu dem elektrischen Testkopf möglichst schnell geschieht, um so möglichst viele elektronische Bauteile in einem vorgegebenen Zeitraum testen zu können.

Zur Erhöhung der Durchsatzraten ist es bekannt, parallel nebeneinander mehrere elektrische Testköpfe anzuordnen, denen dann parallel unabhängig voneinander elektronische Bauteile zum Testen zugeführt werden.

Ein Maß für die Güte der Vorrichtung, die elektronische Bauteile dem elektrischen Testkopf zuführt, ist die sog. Indexzeit. Dies ist die Zeit, die benötigt wird, um ein getestetes Bauteil gegen ein noch zu testendes auszutauschen.

Aus der Druckschrift US 5 801 527 sind eine Vorrichtung und ein Verfahren zum Prüfen von Halbleitern bekannt.

Die Druckschrift US 5 919 024 beinhaltet Vorrichtungen, deren Gebrauch einer Verkürzung der Indexzeit insbesondere beim Prüfen integrierter Schaltkreise dienen soll.

In der Druckschrift US 2004/0164723 A1 wird beschrieben, dass Halbleiter von zwei Seiten alternierend einer Teststation zugeführt und nach erfolgter Prüfung abtransportiert werden.

Die Druckschrift US 4 506 213 offenbart Handler zum Prüfen elektronischer Bauteile.

Die DE 36 34 860 A1 zeigt ein Vorrichtung zum Sortieren elektronischer Bauelemente, die dabei gleichzeitig gewendet werden, für Prüf- oder Testautomaten.

Aufgabe der vorliegenden Erfindung ist es, die Indexzeit zu verkürzen.

Diese Aufgabe wird gelöst durch eine Vorrichtung nach Anspruch 1 sowie durch ein Verfahren nach Anspruch 15.

Bevorzugte Ausführungsformen sind in den Unteransprüchen offenbart.

Die Vorrichtung weist zwei Beladepositionen und eine gemeinsame Testposition auf. Mit Transferelementen kann ein elektronisches Bauteil von jeweils einer oder zwei Beladepositionen der gemeinsamen Testposition zugeführt werden. Während ein elektronisches Bauteil getestet wird, kann somit das andere Transferelement ein getestetes Bauteil ausgeben und ein zu testendes Bauteil aufnehmen.

Die Indexzeit wird somit nur noch durch die Zeit bestimmt, die benötigt wird, die beiden Transferelemente in der Testposition auszutauschen. Die Zeit, die benötigt wird, um ein elektronisches Bauteil aus einem Transferelement auszugeben und dieses mit einem neuen elektronisches Bauteil aus einem Transferelement auszugeben und dieses mit einem neuen elektronischen Bauteil, das getestet werden soll, zu beladen, ist dann nicht mehr relevant. Dies gilt zumindest so lange die elektrische Testzeit länger als die Zeit ist, die benötigt wird, um aus einem Transferelement ein elektronisch getestetes Bauteil zu entfernen und ein zu testendes Bauteil zuzuführen.

Der Weg, den ein Transferelement zwischen der Beladeposition und der Testposition einnehmen kann, kann auf vielfältige Art und Weise ausgestaltet sein. Er kann beispielsweise geradlinig, kurvenförmig, S-förmig sein oder auch aus geradlinigen oder kurvenförmigen oder S-förmigen Stücken zusammengesetzt sein.

Weiterhin kann die Orientierung des Transferelements in der Beladeposition und in der Testposition gleich sein. Dies bedeutet, dass das Transferelement aus der Belade- in die Testposition mit einer reinen Translationsbewegung überführt werden könnte, ohne dass dem eine Drehbewegung des Transferelements überlagert wäre.

Das Vermeiden von überlagerten Drehbewegungen der Transferelemente auf dem Weg zwischen Belade- und Testposition erleichtert ein genaues Positionieren der elektronischen Bauteile in dem Transferelement in der Testposition.

Jedoch ist es auch möglich, dass die Transferelemente in der Belade- und in der Testposition verschiedene Orientierungen einnehmen. Dies erlaubt andere Antriebsweisen und andere Konfigurationen, die zu einer kompakteren Ausführungsform führen.

Weiterhin ist es vorteilhaft, wenn die Wege zwischen den beiden Beladepositionen und der gemeinsamen Testposition zumindest unmittelbar vor der Testposition deckungsgleich verlaufen. Dies erlaubt die Anordnung der beiden Wege in der Art, dass die elektrischen Kontakte des elektrischen Testkopfs möglichst wenig strapaziert werden, da eine quergerichtete Bewegungskomponente beim Kontaktieren der elektrischen Kontakte des elektrischen Testkopfs vermieden wird. Ein senkrechtes Auftreffen auf die Kontakte ist für einen geringen Verschleiß der Kontakte vorteilhaft.

Die Wege für die Transferelemente können auf verschiedenste Weisen realisiert werden. Möglich sind beispielsweise Führungen, wie etwa Stangen, Schienen, Nuten, Kulissen oder Ähnliches. Derartige Ausführungsformen erlauben eine fest vorgegebene Wegführung, die wenig verschleißanfällig ist.

Möglich sind auch flexiblere Ausgestaltungen beispielsweise mit einem Ein-, Zwei oder Mehrachsantrieb, der variable Wege der Transferelemente erlaubt. Die Wege werden beispielsweise bei einem Zwei- oder Mehrachsantrieb durch eine entsprechende Steuereinheit vorgegeben. Durch Umprogrammieren der Steuereinheit können die Wege variiert werden.

Besonders vorteilhaft ist eine Ausführungsform, bei der die beiden Transferelemente mit einem gemeinsamen Antriebsmittel verbunden sind. Dadurch wird es möglich, für beide Transferelemente nur ein Antriebsmittel vorzusehen, was zu einer kostengünstigen Ausführungsform führt.

Die beiden Transferelemente können mit mechanisch starren Verbindungselementen, wie etwa Stangen, Formelementen oder ähnlichem mit dem gemeinsamen Antriebsmittel verbunden sein. Dies erlaubt möglichst einfache und zuverlässige Vorrichtungen.

Besonders vorteilhaft ist als gemeinsames Antriebsmittel ein Drehelement, wie etwa ein Drehteller oder ein Drehzylinder oder auch eine sich drehende Stange, das pneumatisch, elektrisch, hydraulisch oder mit einem Schritt- oder Servomotor angetrieben werden kann. Derartige Antriebsmittel mit einem Drehelement weisen jeweils Teile eines Drehelements mit entgegen gesetzten Bewegungsrichtungen auf, die für die entgegen gesetzten Bewegungen von zwei Transferelementen eingesetzt werden können.

Die elektronischen Bauteile können den beiden Beladepositionen unabhängig über zwei voneinander getrennte Kanäle zugeführt werden. Es ist jedoch auch möglich, einen zumindest teilweise gemeinsamen Kanal vorzusehen, der erst vor den jeweiligen Beladepositionen in zwei Teilkanäle aufgeteilt wird. Bei Ausfall von einer Beladeposition oder von einem Transferelement kann das andere dann, wenn auch mit verringerter Gesamtkapazität weiter betrieben werden. Dies ist besonders vorteilhaft, wenn beispielsweise nur noch wenige Bauteile zu testen sind.

In einer besonders vorteilhaften Ausführungsform ist das ein oder andere oder beide Transferelemente mit jeweils einem weiteren Transferelement gekoppelt. So können beispielsweise zwei Transferelemente übereinander vorgesehen werden, die so miteinander gekoppelt sind, dass sie vorzugsweise gleichzeitig bewegt werden können. Weisen beide Transferelemente jeweils ein weiteres Transferelement auf, so sind also insgesamt vier Transferelemente vorgesehen. So können vorzugsweise jeweils zwei übereinander und jeweils nebeneinander angeordnet sein. Die zwei Transfereiemente übereinander sind zur gleichzeitigen Bewegung miteinander gekoppelt, wohingegen die Elemente nebeneinander zur abwechselnden Bewegung vorgesehen sind.

Die Vorrichtung ist bevorzugter Weise ein Gravity-Handler. Bei einem Gravity Handler werden die zu testenden elektronischen Bauteile durch die Schwerkraft bewegt. Hierbei werden sie entlang eines Transportpfades durch die Schwerkraft bewegt. So können die elektronischen Bauteile beispielsweise in die Transferelemente durch Einwirkung von Schwerkraft einfallen und/oder durch Einwirkung von Schwerkraft aus diesen herausfallen.

Bei einem Gravity Handler ist der Weg, den die elektronischen Bauteile zum Testen nehmen, im wesentlichen senkrecht angeordnet, kann jedoch auch in bestimmten Bereichen leicht geneigt sein.

Den Gegensatz zu Gravity Handlern bilden die so genannten Pick-and-Place Handler, bei denen die elektronischen Bauteile durch entsprechende Vorrichtungen im Wesentlichen horizontal bewegt werden und nicht durch die Schwerkraft bewegt werden, sondern vielmehr kontrolliert mit entsprechenden Einrichtungen bewegt werden. Eine andere Vorrichtung zum Testen von elektronischen Bauteilen weist zwei mechanische Transferelemente auf, die jedoch eine gemeinsame Beladeposition und eine gemeinsame Testposition aufweisen.

Während ein elektronisches Bauteil getestet wird, wird ein getestetes Bauteil aus dem anderen Transferelement entfernt und dieses mit einem zu testenden elektronischen Bauteil beladen. Dies kann gleichzeitig mit dem Testen eines anderen elektronischen Bauteils geschehen, so dass ein Zeitgewinn erreicht wird.

Vorteilhaft ist es hierbei, wenn jedes Transferelement in der gemeinsamen Beladeposition und in der gemeinsamen Testposition jeweils die selbe Orientierung aufweist. Das Vermeiden von Drehbewegungen der Transferelemente führt zu einer besseren Positioniergenauigkeit der elektronischen Bauteile in dem jeweiligen Transferelement.

Hierbei ist es vorteilhaft, dass die beiden Transferelemente mit einem gemeinsamen Antriebselement angetrieben werden, wobei dieses so ausgestaltet ist, dass mit nur einem eine Bewegung der Transferelemente verursachenden Antriebselement die Bewegung von der Belade- in die Testposition erreicht werden kann. Dies erlaubt schnellen Austausch der beiden Transferelemente. Wenn mehrere Antriebselemente für verschiedene Bewegungsabschnitte eingesetzt werden müssen, erhöht dies den Zeitbedarf, da die beiden Bewegungen nacheinander durchgeführt werden müssen. Ausgeschlossen ist eine Ausführungsform mit zwei oder drei oder mehr Antriebsmitteln jedoch nicht.

Auch diese Vorrichtung ist bevorzugter Weise ein Gravity Handler. Hier erfolgt das Beladen der Transferelemente beziehungsweise durch eine Bewegung von elektronischen Bauteilen, die durch die Schwerkraft verursacht wird. Im übrigen gilt beispielsweise das für den oben ausgeführten Gravity Handler gesagte entsprechend.

Bei dem Verfahren wird ein erstes Transferelement mit einem ersten (noch zu testenden) elektronischen Bauteil in einer ersten Beladeposition beladen und zumindest teilweise gleichzeitig ein zweites elektronisches Bauteil in einem zweiten Transferelement in einer Testposition getestet. Nach dem Abschluss des Testens wird das zweite Transferelement aus der Testposition weg bewegt und danach oder zumindest teilweise gleichzeitig das erste Transferelement der gemeinsamen Testposition zugeführt.

Bei einem anderen Verfahren wird ein erstes Transferelement in einer gemeinsamen Beladeposition mit einem ersten (noch zu testenden) elektronischen Bauteil beladen und zumindest gleichzeitig wird ein elektronisches Bauteil eines zweiten Transferelements in einer Testposition getestet. Das zweite Transferelement befindet sich dabei in der Testposition. Danach wird das zweite Transferelement aus der gemeinsamen Testposition weggeführt und danach oder zumindest teilweise gleichzeitig wird das erste Transferelement in die Testposition geführt.

Bevorzugte Ausführungsformen der Erfindung sollen anhand der beiliegenden Figuren erläutert werden. Dabei zeigt:
- Fig. 1: eine schematische Ansicht einer Vorrichtung zum Testen von elektronischen Bauteilen;
- Fig. 2: verschiedene mögliche Konfigurationen für Transferelemente in Belade- und Testposition;
- Fig. 3: eine Detailansicht eines Transferelements;
- Fig. 4: eine dreidimensionale schematische Ansicht eines Transferelements mit Führungen;
- Fig. 5: mögliche Ausführungsformen des Antriebs und der Führung von Transferelementen;
- Fig. 6: eine schematische Ansicht von Zu- und Abführkanälen zusammen mit Transferelementen;
- Fig. 7: eine schematische Ansicht von mehreren Transferelementen nebeneinander und übereinander;
- Fig. 8: ein alternatives Beispiel mit einer gemeinsamen Beladeposition;
- Fig. 9: verschiedene Zustände bei einem Verfahrensablauf.

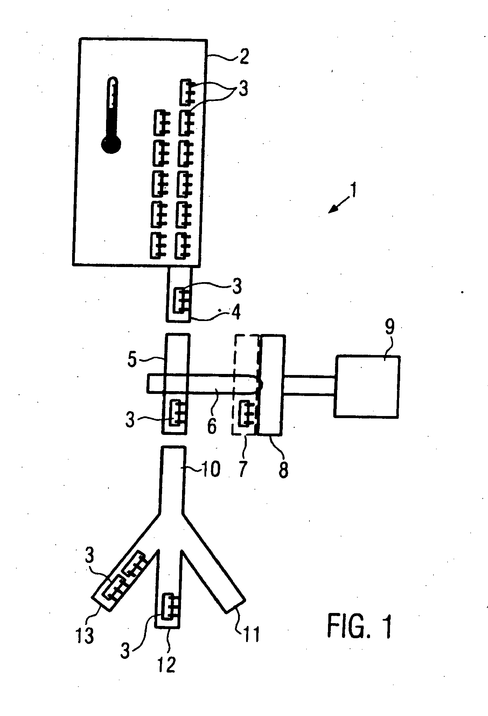

Fig. 1 zeigt eine schematische Ansicht einer Vorrichtung 1 zum Testen von elektronischen Bauteilen 3. Die elektronischen Bauteile 3, wie typischerweise IC-Chips oder ähnliches, können in einer Temperiereinrichtung 2 auf eine vorbestimmte Temperatur aufgeheizt oder gekühlt werden. Die Temperierungseinrichtung 2 muss aber nicht benutzt oder vorgesehen Auch ein Testen der Bauteile bei Raumtemperatur ist möglich.

Wie in Fig. 1 zu sehen ist, ist die Vorrichtung ein Gravity Handler. Der Weg, den die elektronischen Bauteile nehmen, ist im wesentlichen senkrecht.

Aus der Temperierungseinrichtung 2 werden die elektronischen Bauteile 3 heraus vereinzelt und entlang einem Führungskanal 4 zu einem Transferelement 5 geführt. Hierbei kann geeignete Vereinzelungseinrichtung vorgesehen sein und eine oder mehrere Stopper, um die verschiedenen elektronischen Bauteile entlang des Kanals gezielt zu stoppen. Die Bewegungen der elektronischen Bauteile wird durch die Schwerkraft verursacht oder zumindest zum Teil mit verursacht.

Ein elektronisches Bauteil 3 wird in das Transferelement 5 eingebracht (z. B. durch ein reinfallen lassen), wie dies in Fig. 1 dargestellt ist. Das Transferelement 5 kann dann entlang der Führung 6 in die Testposition 7 gebracht werden. Benachbart zu der Testposition 7 ist ein elektrischer Testkopf 8, der von einer schematisiert dargestellten Testeinrichtung 9 angesteuert wird. Mit dem elektrischen Testkopf 8 können die elektrischen Anschlüsse eines elektronischen Bauteils 3 kontaktiert werden, um dieses in Bezug auf seine elektronischen Eigenschaften zu testen.

Nach erfolgtem Test wird das Transferelement 5 aus der Testposition 7 in die Beladeposi-tion zurückgefahren (siehe Fig. 1), um das getestete elektronische Bauteil 3 nach unten auszugeben (z. B. durch schwerkraftbedingtes Herausfallen lassen) und ein neues noch zu testendes elektronisches Bauteil von oben aufzunehmen.

In Fig. 1 ist in der Darstellung nur ein Transferelement 5 zu sehen, da ein zweites Transferelement durch das erste Transferelement abgedeckt wird.

Stromab des Transferelements 5 können verschiedene Verzweigungen vorgesehen sein, um die getesteten elektronischen Bauteile 3 je nach Testergebnis in den ein oder anderen Abführkanal oder Speicher 11, 12, 13 zu leiten.

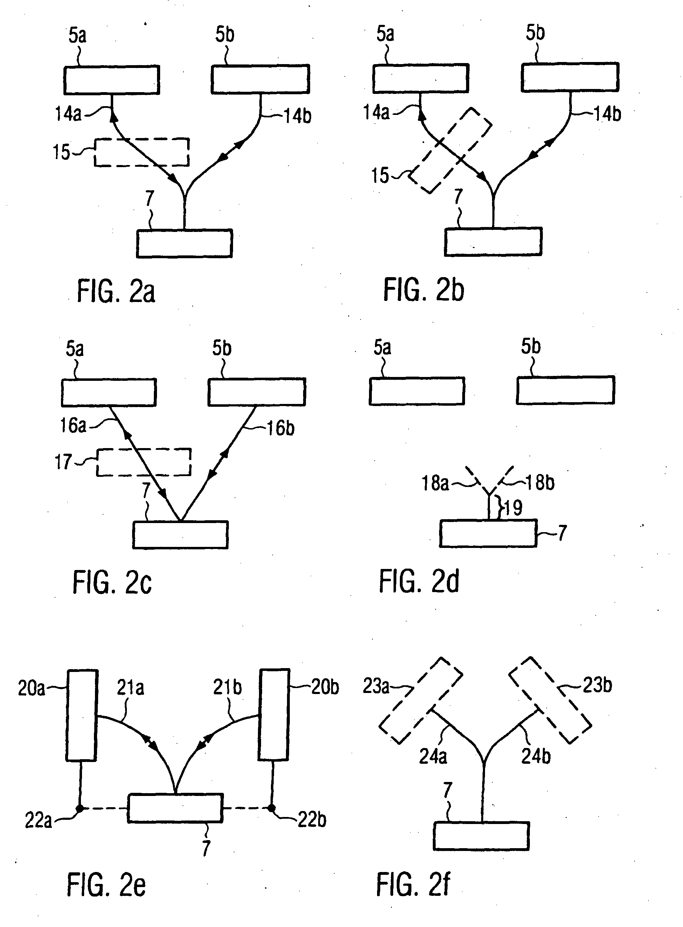

In Fig. 2 sind Schnittansichten in Höhe des Transferelements 5 in der Fig. 1 in Draufsicht gezeigt. Die Darstellungen sind schematisch und zeigen im Wesentlichen die jeweiligen Beladepositionen eines Transferelements 5a, 5b und die Testposition 7.

In Fig. 2a ist ein erstes Transferelement 5a und ein zweites Transferelement 5b nebeneinander angeordnet. Jedes dieser beiden Transferelemente kann mit elektronischen Bauteilen 3 beladen werden (von oben, also aus einer Richtung von oberhalb der Zeichenebene) und jedes dieser Transferelemente kann getestete elektronische Bauteile nach unten (in eine Richtung nach unterhalb der Zeichenebene) ausgeben.

Die beiden Transferelemente 5a, 5b können jedes für sich in die gemeinsame Testposition 7 entlang der Wege 14a, 14b überführt werden. Die Rückführung erfolgt jeweils entlang Weges. Jedoch sind für die Rückführung auch andere Wege möglich.

Bei der in Fig. 2a dargestellten Variante ist eine Zwischenposition mit der Bezugsziffer 15 versehen. Wie ersichtlich, weist das Transferelement 5a in der Position 15 die selbe Orientierung auf wie in der Beladeposition oder in der Testposition 7. Aus der Beladeposition kann das Transferelement 5a mit einer reinen Linearverschiebung in die Position 15 oder die Position 7 überführt werden, ohne dass eine Drehbewegung überlagert wäre. Dies bedeutet, dass die Orientierung jeweils gleich ist.

Alternativ dazu ist in Fig. 2b gezeigt, dass die Zwischenposition 15' im Vergleich zu der Belade- oder Testposition 7 auch gedreht sein kann. Hierbei ist eine solche Ausführungsform vorteilhaft, bei der die Orientierung des Transferelements 5a, 5b im Vergleich zu der Tangente des Weges 14a, 14b, an dem sich das Transferelement 5a, 5b gerade befindet, nicht oder nicht wesentlich ändert. Dies erleichtert eine Führung entlang von vorgegebenen Führungen. Auch wenn in Fig. 2b die Zwischenposition gedreht ist, so weist die Belade- und die Testposition 7 dennoch dieselbe Orientierung auf.

In Fig. 2a und 2b sind die Wege 14a, 14b aus zwei kurvenförmigen Stücken mit entgegen gesetztem Kurvensinn zusammengesetzt. Hiermit ergeben sich im Wesentlichen S-förmige Kurven.

Wie in Fig. 2c gezeigt, können die Transferelemente 5a, 5b in die Testposition 7, aber auch entlang geradlinigen Wegen 16a, 16b geführt werden. Eine entsprechende Zwischenposition ist unter Bezugsziffer 17 dargestellt.

In Fig. 2d ist weiterhin gezeigt, dass unmittelbar vor der Testposition 7 ein Wegstück 19 vorgesehen sein kann, entlang dem die Wege 18a, 18b, die nur hier im Ansatz schematisch gestrichelt dargestellt sind, deckungsgleich übereinander liegen. Dies ermöglicht ein senkrechtes Einlaufen der Transferelemente 5a, 5b auf den elektrischen Testkopf 8. Dadurch wird ein Verschleiß der elektrischen Kontakte des elektrischen Testkopfs 8 verringert, da keine schleifenden Querbewegungen stattfinden, wie dies beispielsweise in Fig. 2c auftreten könnte.

Die Wege 18a und 18b in Fig. 2d können geradlinig oder geschwungen, gebogen, gekrümmt, S-förmig oder sonst wie ausgebildet sein.

In Fig. 2e sind die beiden Beladepositionen von Transferelementen 20a, 20b nicht nebeneinander, sondern gegenüberliegend angeordnet. Aus den Positionen in den Fig. 2a-2d sind die in Fig. 2e gezeigten Positionen durch Drehung um 90° hervorgegangen. Jedoch sind auch größere oder kleinere Drehwinkel als 90°, wie beispielsweise 30°, 45°, 60° oder mehr oder weniger als 30°, 45°, oder 60° denkbar.

Bei der in Fig. 2e dargestellte Ausführungsform kann ein Transferelement 20a, 20b durch eine Schwenkbewegung in die Testposition 7 gebracht werden. Weiterhin ist auch hier ein senkrechtes Einlaufen in die Testposition 7 gewährleistet. Das Transferelement 20a kann um eine Schwenkachse 22a in die Position 7 überführt werden. Dies ist eine reine Rotationsbewegung ohne eine lineare Komponente. Entsprechendes gilt für das Transferelement 20b beim Schwenken um die Achse 22b. Die jeweiligen Wege sind mit 21 a, 21 b bezeichnet.

In Fig. 2f ist eine weitere mögliche Ausführungsform gezeigt, bei der die Beladepositionen der Transferelemente 23a und 23b im Vergleich zu den Positionen in Fig. 2a-2d und 2e diagonal stehen. Aus einer solchen Position heraus kann das Überführen des Transferelements 23a, 23b in die Testposition 7 mit einer reinen Rotationsbewegung oder wie in Fig. 2f dargestellt, mit einer Bewegung, die sich aus einer geradlinigen, einer kurvenförmigen und einer geradlinigen Bewegung zusammengesetzt, erreicht werden. Die benötigten Drehwinkel sind im Vergleich zu Fig. 2e kleiner, so dass die Bewegung schneller durchgeführt werden kann.

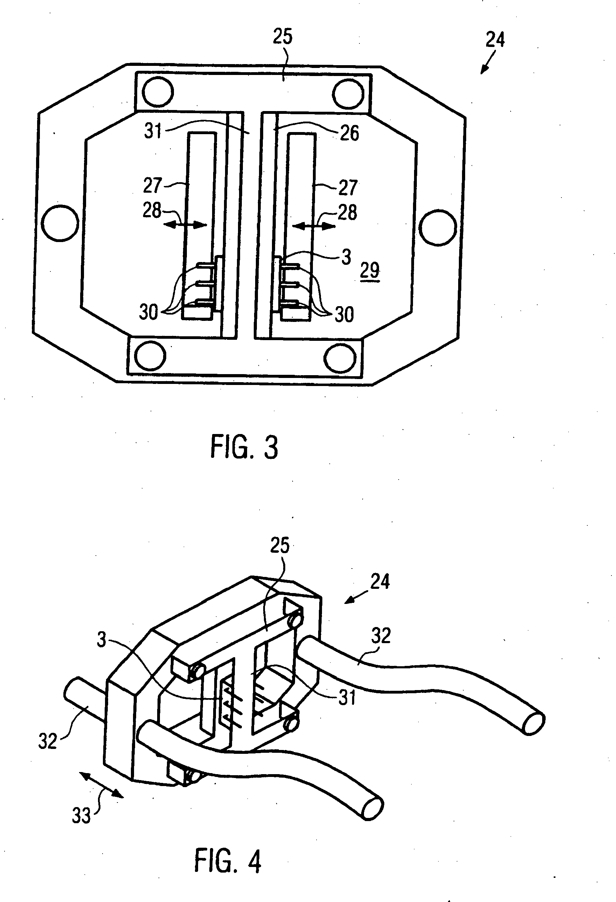

In Fig. 3 ist eine Detailansicht eines Transferelements dargestellt. Dieses trägt die Bezugsziffer 24 und entspricht den Transferelementen 5a, 5b, 20a, 20b, 23a, 23b in Fig. 2.

In Fig. 4 ist eine dreidimensionale schematische Ansicht des Transferelements 24 aus Fig. 3 schematisch dargestellt.

Das Transferelement 24 weist einen Rahmen um eine oder zwei Öffnungen 29 auf, an dem ein doppel-T-förmiges Element 25 mit einem Steg 31 befestigt ist. Zwischen dem Grundkörper des Transferelements 24 und dem Steg 31 kann ein zu testendes elektronisches Bauteil von oben nach unten gleiten. Um das zu testende elektronische Bauteil 3 in dem Transferelement 24 zu halten, ist ein Stopper 27 vorgesehen, der an den elektrischen Kontakten 30 eines zu testenden elektronischen Bauteils 3 mit entsprechenden Vorsprüngen (siehe unteres Ende der Stopper 27) angreifen kann. Andere Stopper, die am Körper zu testenden elektronischen Bauteils angreifen, sind auch zusätzlich oder alternativ möglich. Als Stopper können auch Vakuumöffnungen vorgesehen sein, die ein elektronisches Bauteil festsaugen.

Durch eine Bewegung der Stopper 27 nach außen (Richtung 28) kann das elektronische Bauteil 3 freigegeben werden, so dass es nach unten heraus gleiten kann.

An dem Stegelement 31 des doppel-T-förmigen Teils 25 ist ein Isolatormaterial 26 angeordnet, das dazu dient, die elektrischen Kontakte 30 des elektronischen Bauteils 3 gegen den Steg 31 zu isolieren und das elektronische Bauteil 3 zu führen.

Mit der in Fig. 3 und 4 dargestellten Positionierung des elektronischen Bauteils 3 sind die elektronischen Kontakte von außen zugänglich und können durch die Kontakte des elektrischen Testkopfs 8 kontaktiert werden.

In Fig. 4 ist zusätzlich beispielhaft eine Führung aus Stangen 32 gezeigt. Das Transferelement 24 kann entlang dieser Stangen 32 in Richtung 33 vor- und zurückbewegt werden. Wie in Fig. 4 ersichtlich, ist hiermit beispielsweise eine S-förmige Führung des Transferelements 24 möglich.

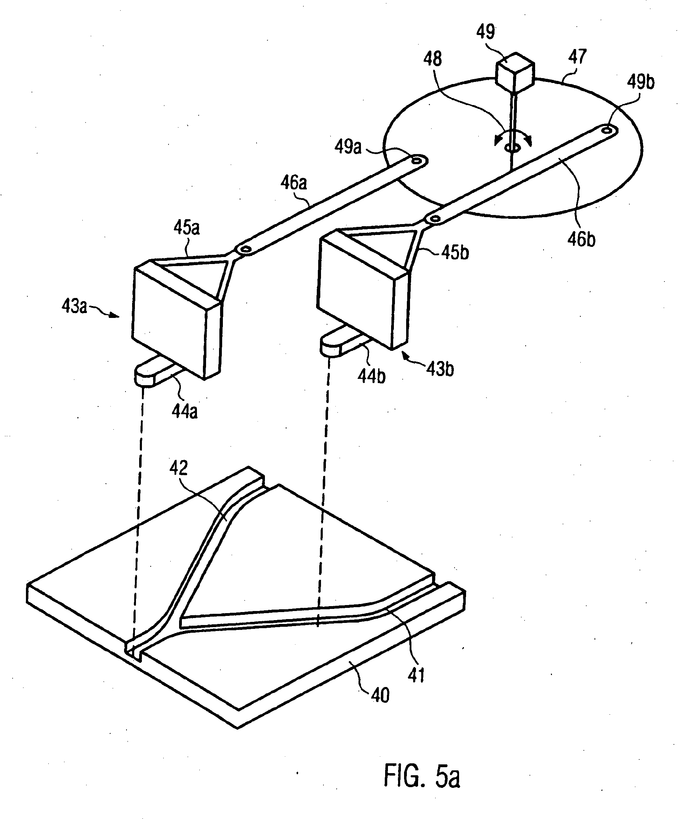

In Fig. 5a ist eine bevorzugte Variante zum Antrieb der Transferelemente gezeigt. Die Transferelemente haben hier Bezugsziffer 43a und 43b.

Eine Platte 40 mit Nuten 41 und 42 ist unterhalb der Transferelemente vorgesehen. Diese Platte 40 ist hier zur besseren zeichnerischen Darstellung nach unten entlang der gestrichelten Linie wie in einer Explosionszeichnung abgesetzt dargestellt.

In den Nuten 41 und 42 können Schiffchen 44a, 44b entlang gleiten. Diese Schiffchen 44a, 44b können zum Teil vor oder hinter dem jeweiligen Transferelement 43a, 43b oder auch davon angeordnet sein.

Die Schiffchen sind vorteilhafter Weise mindestens so lang, dass sie länger sind als das gemeinsame Wegstück der Nuten 41, 42 an dem in Fig. 5a links vorn angeordneten gemeinsamen Wegstück. Dies stellt sicher, dass ein in der Nut 41 einlaufendes Schiffchen 44b auch in dieser Nut wieder zurückgeführt wird. Entsprechendes gilt für das Schiffchen 44a.

Statt zwei ineinander laufenden Nuten können auch zwei getrennte Wegführungen vorgesehen sein. Dies wird z.B. dadurch ermöglicht, dass die Schiffchen nicht mittig bei den Transferelementen liegen, sondern jeweils nach außen hin versetzt sind. Dies ist auch für eine Ausgabe der getesteten elektronischen Bauteile von Vorteil, da sonst ein Schiffchen im Weg sein könnte.

An den Transferelementen 43a, 43b ist jeweils ein Halter 45a oder 45b zusammen mit einer Stange 46a, 46b angeordnet. Die Stangen 46a, 46b sind über Drehpunkte 49a, 49b mit einer rotierbaren Scheibe 47 verbunden.

Die Scheibe 47 kann im Wesentlichen hin- und hergedreht werden, wobei dies durch einen Motor 49 um eine Achse 48 erfolgt. Der Motor 49 kann ein pneumatischer Stellmotor, ein Schrittmotor, ein Servomotor oder sonstiger Motor sein.

Die Verbindung zwischen der rotierbaren Scheibe 47 und den Transferelementen 43a, 43b kann auch über die Schiffchen 44a, 44b erfolgen, indem die Stangen 46 oder die Halter 45 an die Schiffchen angreifen.

Bei dem in Fig. 5a dargestellten Zustand ist das Schiffchen des Transferelements 44a in der Platte 40 ganz vorne, so dass sich das Transferelement 43a in der Testposition befindet. Das andere Schiffchen ist in der rechts angeordneten Beladeposition.

Durch Drehung der Scheibe 47 im Uhrzeigersinn um ca. 150° wird das Transferelement 43a durch die Stange 46a nach hinten gezogen, während gleichzeitig das Transferelement 43b durch die Stange 46 b nach vorne geschoben wird. Dadurch wird das Transferelement 43b in die Testposition gebracht und das Transferelement 43a in die linke Beladeposition zurückgeführt.

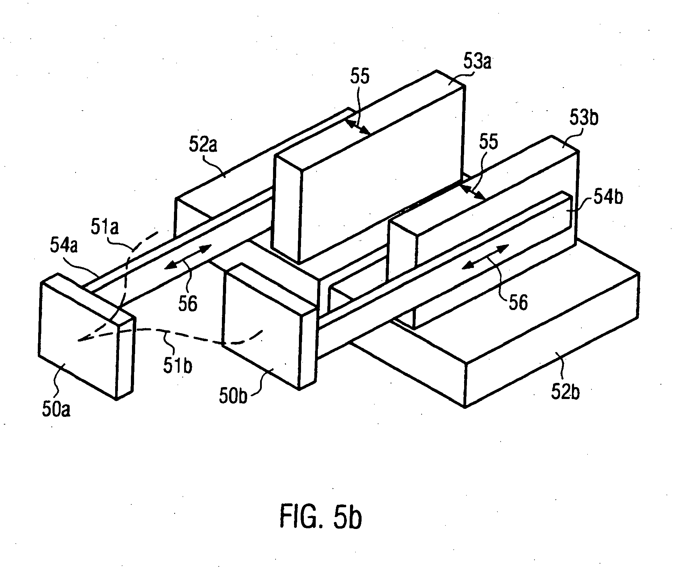

Eine andere Antriebsform ist in Fig. 5b gezeigt. Hier ist für die beiden Transferelemente 50a, 50b die entlang der Wege 51 a und 51 b bewegt werden können, jeweils ein xy-(Zweiachs-) Antrieb vorgesehen. Ein Stellmotor 52b kann einen anderen Stellmotor 53b in Richtung 55 hin- und her bewegen. Der Stellmotor 53b kann einen Träger 54b in einer Richtung 56 vor- und zurückbewegen. Entsprechendes gilt für das andere Transferelement 50a mit dem Stellmotor 52a und 53a, sowie dem Träger 54a.

Mit diesem Antriebsmechanismus ist es möglich, die beiden Transferelemente 50a, 50b vor und zurück und seitwärts zu bewegen. Mit einer überlagerten Bewegung der jeweils beiden Stellmotoren ist eine Bewegung entlang dem Weg 51 a und 51 b möglich. Auch andere Wege sind hier beliebig realisierbar.

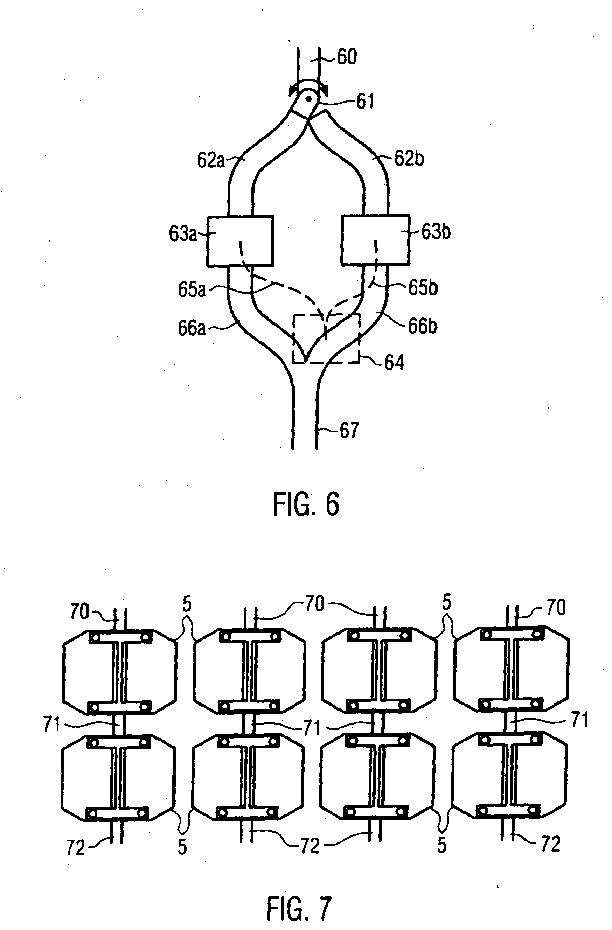

In Fig. 6 sind die Transferelemente 63a und 63b in ihrer jeweiligen Beladeposition gezeigt und der Blick ist in Richtung von dem elektrischen Testkopf auf die Vorrichtung aus Fig. 1 gerichtet. In Richtung vor der Zeichenebene und gestrichelt dargestellt ist die Testposition 64.

Oberhalb der Beladeposition sind Zuführkanäle 62a, 62b für die beiden Beladepositionen dargestellt. Diese können geradlinig sein und / oder unabhängig voneinander. In Fig. 6 ist dennoch eine Ausführungsform gezeigt, bei der beide Kanäle 62a, 62b von einem gemeinsamen Kanal 60 bedient werden. Hier ist schematisch eine Weiche 61 dargestellt, mit der zu testende elektronische Bauteile 3 aus dem Kanal 60 entweder in den Kanal 62a oder in den Kanal 62b gegeben werden können.

Diese Konstruktion führt zu einer gewissen Redundanz, da auch bei Ausfall beispielsweise das Transferelement 63a das andere Transferelement 63b mit dem Kanal 62b weiter arbeiten kann.

Stromab von den Beladepositionen sind hier zwei Kanäle 66a und 66b vorgesehen, die auch unabhängig voneinander gebildet sein können. Bevorzugter Weise führen sie gerade nach unten (siehe auch Fig. 1 mit Kanal 10).

In Fig. 6 ist jedoch eine Ausführungsform dargestellt, bei der die beiden Kanäle 66a und 66b in einen gemeinsamen Kanal 67 münden. Dies ermöglicht die Verwendung von nur einem Kanal mit entsprechenden Verzweigungen in die Behälter 11, 12, 13 (siehe Fig. 1). Bei zwei unabhängigen Kanälen wird die doppelte Anzahl von Verzweigungen benötigt, was mechanisch aufwendiger ist.

Fig. 7 zeigt eine mögliche Anordnung von mehreren Transferelementen 5 nebeneinander und übereinander.

Hier sind vier Transferelemente nebeneinander und zwei Transferelemente übereinander vorgesehen. Elektronische Bauteile 3 können entlang der Kanäle 70, 71, 72 zu- bzw. abgeführt werden.

Die in der oberen Zeile linken beiden Transferelemente 5 können beispielsweise eingesetzt werden, um eine gemeinsame Testposition zu bedienen, wohingegen die in der oberen Zeile rechten beiden Transferelemente dazu benutzt werden können, eine andere Testposition zu bedienen.

Entsprechendes gilt für die unteren Transferelemente 5.

Die jeweils übereinander liegenden Transferelemente 5 sind vorteilhafter Weise direkt oder mittelbar miteinander mechanisch so gekoppelt, so dass sie zusammen bewegt werden. Dadurch ist es möglich, zwei übereinander liegende elektrische Testpositionen jeweils abwechselnd mit den Transferelementen 5 der ersten und zweiten Spalte (in Fig. 7 von links) zu bedienen. Die in Fig. 7 linken vier Transferelemente 5 können mit einem einzelnen Motor angetrieben werden. Entsprechendes gilt für die vier in Fig. 7 rechts angeordneten Transferelemente 5.

Bei dem Wechsel der zu testenden elektronischen Bauteile können die elektronischen Bauteile 3 aus den jeweils oberen Transferelementen 5 durch die unteren Transferelemente 5 hindurch zum Ausgang befördert werden und zu testende elektronische Bauteile für das jeweils untere Transferelement durch das obere Transferelement hindurch geleitet werden.

Alternatives Beispiel mit nur einer Beladeposition

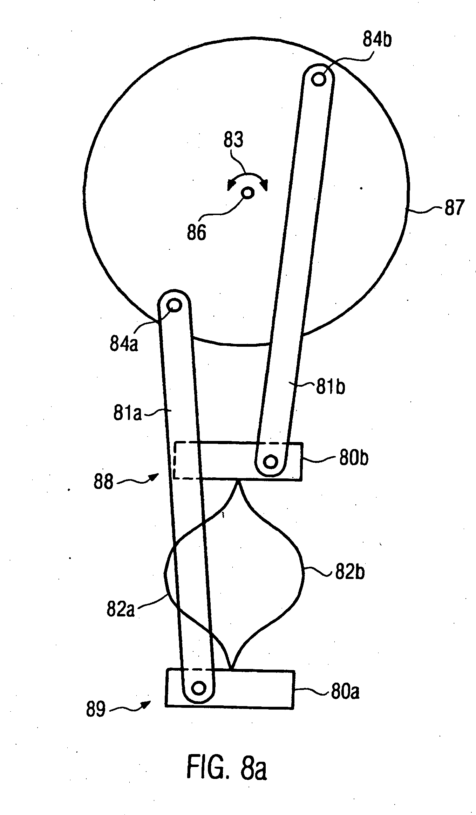

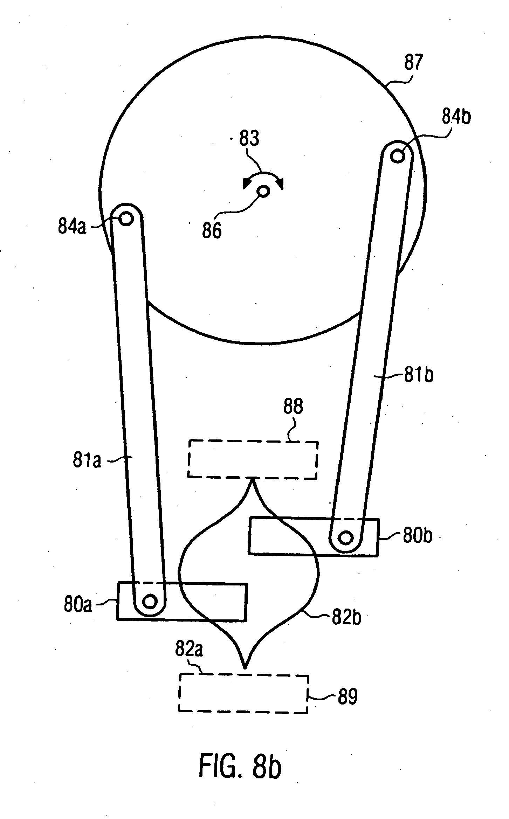

In Fig. 8 ist ein anderes Beispiel zur Veranschaulichung gezeigt, bei dem eine gemeinsame Beladeposition für zwei Transferelemente 80a, 80b vorgesehen ist. Zwischen der Beladeposition 88 und der Testposition 89 sind zwei Wege 82a und 82b vorgesehen, wobei das Transferelement 80b entlang des Wegs 82b und das Transferelement 80a entlang des Wegs 82a bewegt werden soll (siehe auch Fig. 8b).

Der Antrieb erfolgt ähnlich wie in Fig. 5a mit einem Drehelement 87 und zwei Stangen 81 a, 81 b, die jeweils an Drehpunkten 84a, 84b gelagert sind. Die Stangen greifen hier unmittelbar an die Transferelemente 80a, 80b an, wie dies auch in Fig. 5a möglich ist.

Durch Drehung (siehe Doppelpfeil 83) der Scheibe 87 aus der Position in Fig. 8a heraus im Uhrzeigersinn (siehe Fig. 8b) um eine Achse 86 können die beiden Transferelemente jeweils entlang ihres Weges bewegt werden und aneinander vorbei geführt werden. Dadurch ist ein Wechsel der beiden Transferelemente zwischen Belade- und Testposition möglich.

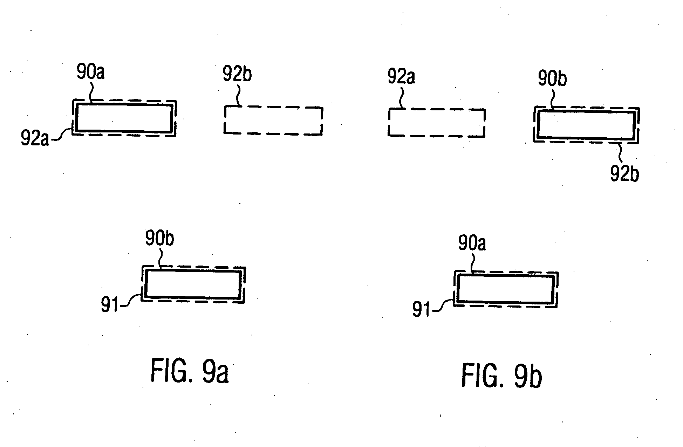

Eine Verfahrensweise soll beispielhaft anhand von Fig. 9 erläutert werden.

In Fig. 9a ist ein Transferelement 90a in einer Beladeposition 92a dargestellt. In dieser Position kann es mit einem zu testenden elektronischen Bauteil beladen werden.

Das andere Transferelement 90b befindet sich in der gemeinsamen Testposition 91. Dort kann es durch den elektrischen Testkopf 8 (siehe Fig. 1) getestet werden.

Nach Abschluss des elektrischen Tests wird das Transferelement 90b aus der gemeinsamen Testposition 91 in die Beladeposition 92b überführt (siehe Fig. 9b). In dieser Position kann das getestete elektronische Bauteil nach unten ausgegeben werden (siehe Fig. 1 und 6) und mit einem neuen zu testenden Bauteil beladen werden.

Während sich das Transferelement 90b aus der gemeinsamen Testposition 91 in die Beladeposition 92b bewegt oder zumindest zeitweise während dieser Bewegung oder auch danach kann das Transferelement 90a aus der Beladeposition 92a in die gemeinsame Testposition 91 überführt werden. Dort kann das Bauteil dann getestet werden.

Sobald dieses Bauteil getestet ist, wird das Transferelement 90a aus der gemeinsamen Testposition 91 wieder in die Beladeposition 92a zurück bewegt (siehe Fig. 9a) und währenddessen oder danach kann das Transferelement 90b aus der Beladeposition mit dem neuen zu testenden elektronischen Bauteil aus der Beladeposition 92b in die gemeinsame Testposition 91 überführt werden (siehe Fig. 9a). Dieser Ablauf kann dann wiederholt werden, um viele Bauteile zu testen.

Die Verfahrensweise bei der Vorrichtung aus Fig. 8 ist genau gleich bis auf, dass nicht zwei separate Positionen 92a, 92b vorgesehen sind, sondern eine gemeinsame Beladeposition.

Für den Fall, dass die Be- und Entladezeiten im Vergleich zu den elektrischen Testzeiten sehr lang sind, kann es vorteilhaft sein, statt zweier Beladepositionen auch drei Beladeposi- tionen vorzusehen, aus denen nacheinander elektronische Bauelemente in eine gemeinsame Testposition Oberführt werden können.

Lange Be- und Entladezeiten können sich insbesondere dann ergeben, wenn mehrere Transferelemente übereinander angeordnet sind (siehe Fig. 7). Auch hier ist es möglich, nicht nur zwei Elemente, sondern auch drei, vier, fünf oder mehr Elemente übereinander anzuordnen.

## Patentansprüche

1. Vorrichtung zum Testen von elektronischen Bauteilen (3) umfassend:
mindestens zwei mechanischen Transferelementen (5a, 5b, 90a 90b), von denen jedes jeweils an einer eigenen von zwei unterschiedlichen, räumlich voneinander getrennten Beladepositionen (92a; 92b) mit einem elektronischen Bauteil (3) beladen werden kann,
**dadurch gekennzeichnet, dass**
eine gemeinsame Testposition (7) für die elektronischen Bauteile (3) vorgesehen ist, in die die zwei Transferelemente (5a, 5b) gebracht werden können,
wobei die Vorrichtung so ausgebildet ist, dass sie die Transferelemente (5a, 5b) zwischen der Beladeposition (92a; 92b) und der Testposition (7) bewegen kann, und
wobei die Transferelemente so angeordnet sind, dass die elektronischen Bauteile in die Transferelemente durch Einwirkung von Schwerkraft hineinfallen und durch Einwirkung von Schwerkraft aus diesen herausfallen können.

2. Vorrichtung nach Anspruch 1, **dadurch gekennzeichnet, dass** der Weg der Transferelemente (5a, 5b) von einer Beladeposition (5a, 5b) zu der Testposition (7) geradlinig (16a, 16b), kurvenförmig (14a, 14b, 21a, 12b, 23a, 23b), s-förmig (14a, 14b) oder aus geradlinigen und kurvenförmigen Stücken zusammengesetzt ist.

3. Vorrichtung nach Anspruch 1 oder 2, **dadurch gekennzeichnet, dass** mindestens ein oder zwei Transferelemente (5a, 5b) in der Beladeposition die gleiche Orientierung aufweisen wie in der Testposition (7).

4. Vorrichtung nach Anspruch 3, **dadurch gekennzeichnet, dass** mindestens ein oder zwei Transferelemente (5a, 5b) auf dem Weg zwischen Beladeposition und Testposition (7) immer die Orientierung wie in der Belade- und Testposition aufweisen.

5. Vorrichtung nach Anspruch 3, **dadurch gekennzeichnet, dass** ein oder zwei Transferelemente (5a, 5b) zumindest auf einem oder mehreren Teilen des Wegs zwischen Beladeposition und Testposition (7) oder auch auf dem gesamten Weg eine gedrehte Orientierung im Vergleich zu der Orientierung wie in der Belade- und Testposition (7) aufweisen.

6. Vorrichtung nach einem der Ansprüche 1 oder 2, **dadurch gekennzeichnet, dass** mindestens ein oder zwei Transferelemente (20a, 20b, 23a, 23b) in der Beladeposition und in der Testposition eine verschiedene Orientierung aufweisen.

7. Vorrichtung nach einem der Ansprüche 1 bis 6, **dadurch gekennzeichnet, dass** die Wege zwischen den beiden Beladepositionen und der Testposition zumindest im Bereich (19) unmittelbar vor der Testposition (7) deckungsgleich verlaufen.

8. Vorrichtung nach einem der Ansprüche 1 bis 7, **dadurch gekennzeichnet, dass** die Wege für die Transferelemente (24, 43a, 43b) zwischen Beladeposition und Testposition durch Führungen wie etwa Stangen (32), Schienen, Nuten (41, 42) oder Kulissen vorgegeben werden.

9. Vorrichtung nach einem der Ansprüche 1 bis 8, **dadurch gekennzeichnet, dass** die Transferelemente (50a, 50b) zwischen Beladeposition und Testposition jeweils durch einen Ein-, Zwei- oder Mehrachsantrieb (52, 53, 54) bewegt werden.

10. Vorrichtung nach einem der Ansprüche 1 bis 9, **dadurch gekennzeichnet, dass** die beiden Transferelemente (43a, 43 b) mit einem gemeinsamen Antriebsmittel (47, 49) verbunden sind.

11. Vorrichtung nach Anspruch 10, **dadurch gekennzeichnet, dass** die beiden Transferelemente (43a, 43b) mit mechanisch starren Verbindungselementen wie etwa Stangen (46a, 46b) oder Formelementen mit dem gemeinsamen Antriebsmittel (47, 49) verbunden sind.

12. Vorrichtung nach Anspruch 10 oder 11, **dadurch gekennzeichnet, dass** das gemeinsame Antriebsmittel ein Drehelement (47) wie etwa einen Drehteller oder einen Drehzylinder umfasst, der pneumatisch, elektrisch, hydraulisch, mit einem Schritt- oder Servomotor (49) angetrieben werden kann.

13. Vorrichtung nach einem der Ansprüche 1 bis 12, **dadurch gekennzeichnet, dass** elektronische Bauteile den beiden Beladepositionen unabhängig voneinander zugeführt werden können oder dass den beiden Beladepositionen elektronische Bauteile über einen zumindest teilweise gemeinsamen Kanal (60) zugeführt werden.

14. Vorrichtung nach einem der Ansprüche 1 bis 13, **dadurch gekennzeichnet, dass** mindestens ein oder zwei Transferelemente (5) mit jeweils einem weiteren Transferelement gekoppelt sind.

15. Verfahren zum Testen von elektronischen Bauteilen (3) mit den Schritten:
ein erstes Transferelement wird in einer ersten Beladeposition des ersten Transferelements mit einem elektronischen Bauteil beladen, wobei das Bauteil in das Transferelement durch Einwirkung von Schwerkraft einfällt;
zumindest teilweise gleichzeitig wird ein elektronisches Bauteil in einem zweiten Transferelement, das sich in einer gemeinsamen Testposition befindet, getestet;
nach dem Testen des elektronischen Bauteils des zweiten Transferelements wird dieses einer zweiten, von der ersten Beladeposition verschiedenen und räumlich getrennten Beladeposition zugeführt, um es durch schwerkraftbedingtes Herausfallenlassen nach unten auszugeben;
danach oder zumindest teilweise gleichzeitig wird das erste Transferelement der gemeinsamen Testposition zugeführt.

## Claims

1. Device for testing electronic components (3), comprising:
at least two mechanical transfer elements (5a, 5b, 90a, 90b), each of which respectively can be loaded with an electronic component (3) at a separate one of two different loading positions (92a; 92b) spatially separate from one another,
**characterised in that**
a common test position (7) is provided for the electronic components (3) into which the two transfer elements (5a, 5b) can be moved,
and the device is designed so that it is able to move the transfer elements (5a, 5b) between the loading position (92a; 92b) and the test position (7), and
the transfer elements are disposed so that the electronic components are able to drop into the transfer elements under the effect of gravity and drop out of them under the effect of gravity.

2. Device as claimed in claim 1, **characterised in that** the path of the transfer elements (5a, 5b) from a loading position (5a, 5b) to the test position (7) is straight (16a, 16b), curved (14a, 14b, 21a, 12b, 23a, 23b), s-shaped (14a, 14b) or made up of straight and curved parts.

3. Device as claimed in claim 1 or 2, **characterised in that** at least one or two transfer elements (5a, 5b) have the same orientation in the loading position as in the test position (7).

4. Device as claimed in claim 3, **characterised in that** at least one or two transfer elements (5a, 5b) always have the same orientation on the path between the loading position and test position (7) as in the loading and test positions.

5. Device as claimed in claim 3, **characterised in that** one or two transfer elements (5a, 5b) have a rotated orientation at least on one or more parts of the path between the loading position and test position (7) or also on the entire path compared with the orientation in the loading and test position (7).

6. Device as claimed in one of claims 1 or 2, **characterised in that** at least one or two transfer elements (20a, 20b, 23a, 23b) have a different orientation in the loading position and in the test position.

7. Device as claimed in one of claims 1 to 6, **characterised in that** the paths between the two loading positions and the test position extend congruently at least in the region (19) directly in front of the test position (7).

8. Device as claimed in one of claims 1 to 7, **characterised in that** the paths for the transfer elements (24, 43a, 43b) between the loading position and test position are predefined by guides such as rods (32), rails, grooves (41, 42) or cranks.

9. Device as claimed in one of claims 1 to 8, **characterised in that** the transfer elements (50a, 50b) are moved between the loading position and test position respectively by a single-, dual- or multi-axle drive (52, 53, 54).

10. Device as claimed in one of claims 1 to 9, **characterised in that** the two transfer elements (43a, 43b) are connected to a common drive means (47, 49).

11. Device as claimed in claim 10, **characterised in that** the two transfer elements (43a, 43b) are connected to the common drive means (47, 49) by mechanically rigid connecting elements such as rods (46a, 46b) or shaped elements.

12. Device as claimed in claim 10 or 11, **characterised in that** the common drive means comprises a rotating element (47) such as a rotary plate or a rotating cylinder which can be pneumatically, electrically or hydraulically driven by a stepper or servo-motor (49).

13. Device as claimed in one of claims 1 to 12, **characterised in that** electronic components are fed to the two loading positions independently of one another or electronic components are fed to the two loading positions via an at least partially common passage (60).

14. Device as claimed in one of claims 1 to 13, **characterised in that** at least one or two transfer elements (5) are coupled respectively with one other transfer element.

15. Method of testing electronic components (3) comprising
the steps:
a first transfer element in a first loading position of the first transfer element is loaded with an electronic component, the component dropping into the transfer element under the effect of gravity;
an electronic component in a second transfer element disposed in a common test position is tested at least partially simultaneously;
after testing the electronic component of the second transfer element, the latter is fed to a second loading position different from and spatially separate from the first loading position in order to discharge it by allowing it to drop downwards under the effect of gravity;
thereafter or at least partially simultaneously, the first transfer element is fed to the common test position.

## Revendications

1. Dispositif destiné à tester des composants électroniques (3), comprenant :
au moins deux éléments de transfert mécaniques (5a, 5b, 90a, 90b), dont chacun peut être chargé avec un composant électronique (3) respectivement au niveau d'une, qui lui est propre, de deux positions de chargement (92a; 92b) différentes, séparées l'une de l'autre spatialement,
caractérisé
en ce qu'il est prévu une position de test (7) commune pour les composants électroniques (3), dans laquelle peuvent être amenés les deux éléments de transfert (5a, 5b),
le dispositif étant conçu de manière à pouvoir déplacer les éléments de transfert (5a, 5b) entre la position de chargement (92a; 92b) et la position de test (7), et
les éléments de transfert étant agencés de manière telle, que les composants électroniques puissent tomber dans les éléments de transfert sous l'effet de la gravité, et puissent tomber hors de ceux-ci sous l'effet de la gravité.

2. Dispositif selon la revendication 1, **caractérisé en ce que** la trajectoire des éléments de transfert (5a, 5b) de la position de chargement (5a, 5b) à la position de test (7) est de forme rectiligne (16a, 16b), de forme courbe (14a, 14b, 21a, 12b, 23a, 23b), en forme de S (14a, 14b), ou est constituée de portions rectilignes et de forme courbe.

3. Dispositif selon la revendication 1 ou la revendication 2, **caractérisé en ce qu'**au moins un ou deux éléments de transfert (5a, 5b) présentent la même orientation dans la position de chargement que dans la position de test (7).

4. Dispositif selon la revendication 3, **caractérisé en ce qu'**au moins un ou deux éléments de transfert (5a, 5b) présentent toujours, sur la trajectoire entre la position de chargement et la position de test (7), l'orientation telle que dans la position de chargement et de test.

5. Dispositif selon la revendication 3, **caractérisé en ce qu'**un ou deux éléments de transfert (5a, 5b) présentent, tout au moins sur une ou plusieurs parties de la trajectoire entre la position de chargement et la position de test (7) ou sur l'ensemble de la trajectoire, une orientation tournée par rapport à l'orientation telle que dans la position de chargement et de test (7).

6. Dispositif selon l'une des revendications 1 ou 2, **caractérisé en ce qu'**au moins un ou deux éléments de transfert (20a, 20b, 23a, 23b) présentent une orientation différente dans la position de chargement et dans la position de test.

7. Dispositif selon l'une des revendications 1 à 6, **caractérisé en ce que** les trajectoires entre les deux positions de chargement et la position de test présentent une étendue mutuellement coïncidente au moins dans la zone (19) directement avant la position de test (7).

8. Dispositif selon l'une des revendications 1 à 7, **caractérisé en ce que** les trajectoires pour les éléments de transfert (24, 43a, 43b) entre la position de chargement et la position de test sont prédéterminées par des guidages comme par exemple des tiges (32), des rails, des rainures (41, 42) ou des coulisses.

9. Dispositif selon l'une des revendications 1 à 8, **caractérisé en ce que** les éléments de transfert (50a, 50b) sont déplacés entre la position de chargement et la position de test, respectivement par un entraînement à un, deux ou plusieurs axes (52, 53, 54).

10. Dispositif selon l'une des revendications 1 à 9, **caractérisé en ce que** les deux éléments de transfert (43a, 43b) sont reliés à un moyen d'entraînement (47, 49) commun.

11. Dispositif selon la revendication 10, **caractérisé en ce que** les deux éléments de transfert (43a, 43b) sont reliés au moyen d'entraînement (47, 49) commun, par des éléments de liaison mécaniquement rigides comme par exemple des tiges (46a, 46b) ou des éléments de forme.

12. Dispositif selon la revendication 10 ou la revendication 11, **caractérisé en ce que** le moyen d'entraînement commun comprend un élément rotatif (47) comme par exemple un disque rotatif ou un cylindre rotatif, qui peut être entraîné par voie pneumatique, électrique, hydraulique, à l'aide d'un moteur pas à pas ou d'un servomoteur (49).

13. Dispositif selon l'une des revendications 1 à 12, **caractérisé en ce que** des composants électroniques peuvent être amenés aux deux positions de chargement de manière mutuellement indépendante, ou des composants électroniques sont amenés aux deux positions de chargement par l'intermédiaire d'un canal (60) au moins partiellement commun.

14. Dispositif selon l'une des revendications 1 à 13, **caractérisé en ce qu'**au moins un ou deux éléments de transfert (5) sont couplés respectivement à au moins un autre élément de transfert.

15. Procédé pour tester des composants électroniques (3) comprenant les étapes suivantes :
un premier élément de transfert est chargé avec un composant électronique, dans une première position de chargement du premier élément de transfert, le composant électronique tombant dans l'élément de transfert sous l'effet de la gravité ;
au moins partiellement de manière simultanée, un composant électronique est testé dans un deuxième élément de transfert qui se trouve dans une position de test commune ;
après le test du composant électronique du deuxième élément de transfert, celui-ci est amené dans une deuxième position de chargement, qui est différente de la première position de chargement et séparée spatialement de celle-ci, pour l'évacuer vers le bas en le laissant tomber sous l'effet de la gravité ;
ensuite, ou au moins partiellement de manière simultanée, le premier élément de transfert est amené à la position de test commune.
